# EUROPEAN PATENT SPECIFICATION

(11) **EP 4 080 772 B1**
(45) Date of publication and mention of the grant of the patent: **09.12.2026**
(21) Application number: 21779441.1
(22) Date of filing: 30.03.2021
(51) Int. Cl.: H03M 13/35, H03M 13/37, H03M 13/00, H03M 13/09, H04L 1/00

(54) **TRANSMISSION PROCESSING METHOD AND DEVICE**
ÜBERTRAGUNGSVERARBEITUNGSVERFAHREN UND -VORRICHTUNG
PROCÉDÉ ET DISPOSITIF DE TRAITEMENT DE TRANSMISSION

(30) Priority: 31.03.2020 CN 202010246128
(43) Date of publication of application: 26.10.2022
(73) Proprietor: Vivo Mobile Communication Co., Ltd., Dongguan, Guangdong 523863 (CN)
(72) Inventor: SUN, Peng, Dongguan, Guangdong 523863 (CN); WU, Huaming, Dongguan, Guangdong 523863 (CN); QIN, Fei, Dongguan, Guangdong 523863 (CN); WU, Yumin, Dongguan, Guangdong 523863 (CN)
(74) Representative: Murgitroyd & Company
(86) International application number: PCT/CN2021/083896
(87) International publication number: WO 2021/197309

(56) References cited:
- EP-A1- 4 084 374
- EP-B1- 3 127 377
- WO-A1-02/101652
- WO-A1-2020/035683
- WO-A1-2020/035683
- CN-A- 101 783 940
- CN-A- 103 262 630
- CN-A- 110 493 603
- US-A1- 2011 268 187
- US-A1- 2012 155 398
- WANG LIN, LIU SANYA;CHEN CHEN;CHEN QIWANG: "Overview of Low Power Data Link Algorithms Design for Industrial Internet——Necessity, Reality and Prospect of JSCC Design", JOURNAL OF ELECTRONICS & INFORMATION TECHNOLOGY, KEXUE CHUBANSHE, vol. 42, no. 1, 31 January 2020 (2020-01-31), Kexue Chubanshe, pages 249 - 262, XP055855094, ISSN: 1009-5896, DOI: 10.11999/JEIT190762

## Description

### TECHNICAL FIELD

The present invention relates to the field of communications technologies, and in particular, to a transmission processing method and a device.

### BACKGROUND

Shannon's separation theorem pointed out that source encoding and channel encoding can be optimized separately without sacrificing the overall system performance. Current information systems are all designed based on the principle. For example, in a video service performed through a 5G (5th-Generation, 5th-generation mobile communication technology) network, a video server is responsible for source encoding while the 5G network is responsible for transmitting a source-encoded bit to a terminal side according to quality of service (Quality of Service, QoS) requirements. During transmission between different nodes, the 5G network uses different channel encoding to match different channel conditions (e.g. a wired or wireless condition).

However, premises for proving the Shannon's separation theorem are a point-to-point system between a single transmitter and a single receiver, a stable channel, and an unlimited packet length, but the three premises are not satisfied in an actual system. In this way, the current method of separately performing source encoding and channel encoding processing generally increases the processing time and wastes resources.

US20120155398A1 discloses that an approach to enhance quality of experience (QoE) in a wireless multimedia communication system is disclosed. A signaling mechanism is provided to make application-layer parameters of a multimedia application to be accessible in one or more network interfaces including an air interface, an access network interface, and a core network interface. Also, the application-layer parameters may be included in quality of service (QoS) class definitions to make the application-layer parameters accessible at the one or more network interfaces. The signaling mechanism and inclusion of application layer parameters into the QoS class definitions is to enable the QoE-aware link adaptation, resource allocation, joint source channel coding based cross-layer optimizations.

WO2020035683A1 discloses a communication system for conveying information from an information source across a communications channel using a joint source channel coding variational autoencoder, comprising an encoder neural network of the joint source channel coding variational autoencoder, the encoder neural network having an input layer and a channel input layer coupled to the input layer through one or more neural network layers; and a decoder neural network of the joint source channel coding variational autoencoder; and an output layer coupled to the channel output layer through one or more neural network layers.

### SUMMARY

The embodiments of the present invention provide a transmission processing method and a device, to resolve an existing problem of time consumption of encoding and decoding processing during transmission.

To resolve the above technical problems, the present invention is implemented as follows:

According to a first aspect, an embodiment of the present invention provides a transmission processing method, performed by a first communication device, the method being defined in claim 1.

According to a second aspect, an embodiment of the present invention further provides a communication device, the communication device being a first communication device which is defined in claim 8.

According to a third aspect, an embodiment of the present invention further provides a computer-readable storage medium, which is defined in claim 11.

Further advantageous embodiments of the present disclosure are indicated in the dependent claims. It is to be understood that both the foregoing general description and the following detailed description are exemplary only, and are not restrictive of the present disclosure.

### BRIEF DESCRIPTION OF THE DRAWINGS

FIG. 1 is a schematic diagram of steps of a transmission processing method according to an embodiment of the present invention;
FIG. 2 is a first schematic structural diagram of a specific scenario;
FIG. 3 is a second schematic structural diagram of a specific scenario;
FIG 4 is a structural diagram of a communication device according to an embodiment of the present invention; and
FIG. 5 is a structural diagram of a communication device according to another embodiment of the present invention.

### DETAILED DESCRIPTION

To make the technical problems to be resolved, technical solutions, and advantages of the present invention clearer, a detailed description is made below with reference to accompanying drawings and specific embodiments.

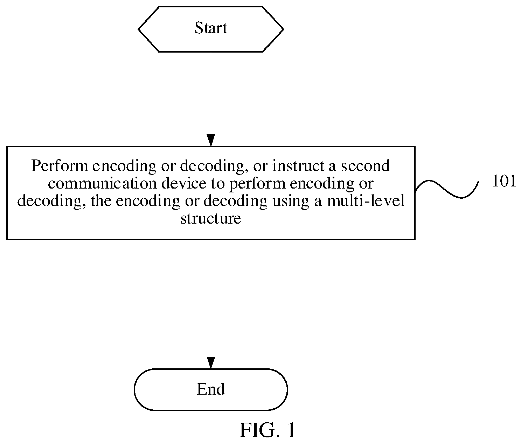

As shown in FIG. 1, an embodiment of the present invention provides a transmission processing method, performed by a first communication device, the method including:
Step 101: Perform encoding or decoding, or, instruct a second communication device to perform encoding or decoding, where the encoding or decoding uses a multi-level structure.

The multi-level structure includes a two-level structure or a more-level structure. According to step 101, the first communication device to which the method according to the embodiments of the present invention is applied can perform encoding or decoding by using the multi-level structure, or instruct the second communication device to perform encoding or decoding by using the multi-level structure, so as to effectively reduce time consumption of encoding and decoding processing during transmission.

The second communication device is a peer device of this transmission.

In this embodiment, encoding or decoding is based on a deep learning neural network.

It should be understood that the communication device may be a user-side device, or may be a network-side device. The user-side device may refer to an access terminal, a subscriber unit, a subscriber station, a mobile station, a mobile console, a remote station, a remote terminal, a mobile device, a user terminal, a terminal, a wireless communication device, a user agent, or a user apparatus. The user-side device may alternatively be a cellular phone, a cordless phone, a session initiation protocol (session initiation protocol, SIP) phone, a wireless local loop (wireless local loop, WLL) station, a personal digital assistant (personal digital assistant, PDA), a handheld device with a wireless communication function, a computing device, another processing device connected to a wireless modem, an in-vehicle device, or a wearable device. The network-side device may be a base station, a network server, a source (content) server, or the like.

An overall objective of the multi-level structure is to reduce a source loss as much as possible with less air interface resource overheads, such as multiplexing an existing protocol stack structure as much as possible.

The multi-level structure includes at least a first part and a second part,
where the number of output bits in encoding of the first part is greater or equal to the number of input bits in encoding of the first part, and the number of output bits in encoding of the second part is smaller than or equal to the number of input bits in encoding of the second part; and the number of output bits in decoding of the first part is smaller than the number of input bits in decoding of the first part, and the number of output bits in decoding of the second part is greater than the number of input bits in decoding of the second part.

An objective of the second part is to reduce the number of bits transmitted and exchanged in a transmission network; and an objective of the first part is to improve the reliability of bits during air interface transmission. In this way, during training of the deep learning neural network of encoding or decoding, the overall objective of the multi-level structure, the objective of the first part, and the objective of the second part need to be taken into consideration at the same time.

Optionally, if the multi-level structure is a two-level structure, the first part corresponds to a first-level structure of the two-level structure, and the second part corresponds to a second-level structure of the two-level structure.

For the user-side device, the multi-structure used by encoding or decoding can all be performed in a physical layer.

For the network-side device, considering that during transmission, the network-side device includes multiple devices, such as a base station, a network server, and a source (content) server. Optionally, in a case that the first communication device is a network-side device, different parts of the multi-level structure are processed in different network elements or modules of the network-side device.

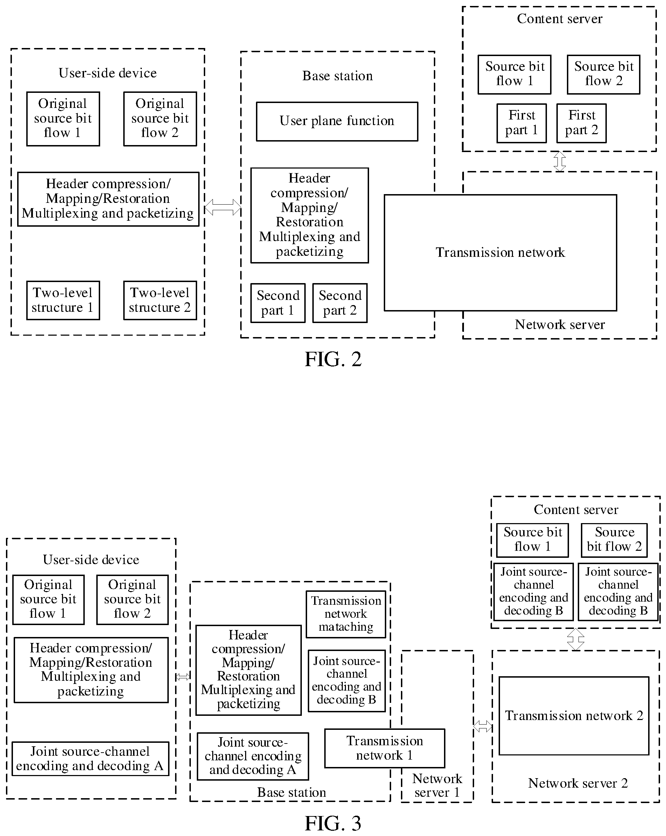

For example, in a scenario shown in FIG. 2, the content server is located at an edge of a network, and encoding or decoding of the network-side device uses a two-level structure, where a second part is implemented by the base station and the first part is implemented by the content server. If the user-side device performs encoding and the network-side device performs decoding, because the base station only performs first level decoding on the second part, a header cannot be identified, so that a corresponding packet cannot be further transmitted to a corresponding server, and multiplexing and packetizing of a medium access control MAC layer are also affected. Therefore, header information is carried in control information, for example: the header information may be directly carried in downlink control information DCI or uplink control information UCI, or may be carried in a medium access control control element MAC CE, or may be carried in a manner similar to two-level DCI/UCI considering that the header information may be relatively large. If the header information is carried in a MAC CE, a separate network needs to be used and a manner that the header information is reused with data is defined. A good interaction between the network server and the content server can match a corresponding channel change in real time.

If in a scenario shown in FIG. 3, the content server is deployed separately, transmission between the user-side device and the network-side device can be performed through multiple times of joint source-channel coding:
joint source-channel coding A is used between the base station and the user-side device, where the joint coding manner only needs to be aligned between the base station and the user side device; and
joint source-channel coding B is used between the base station or the network server and the content server, where this part can also use a traditional source or channel encoding structure and the joint coding is not necessarily needed.

In the scenario shown in FIG. 3, the header information is carried in control information. In this way, mixing of the header and a service stream may affect the efficiency of joint coding. If a relationship between an Internet Protocol (Internet Protocol, IP) quintuple and a corresponding bearer can be established in advance, the user-side device may omit IP layer processing, to reduce the processing complexity and avoid the limit of 1500 bytes.

In addition, in this embodiment, the user-side device and the network-side device need to have the same understanding of encoding or decoding using a multi-level structure.

The method further includes:
sending or receiving encoding and decoding indication information, where the encoding and decoding indication information includes at least one of the following:
whether to use channel encoding;
whether to use joint source-channel encoding;
whether to use a type of encoding with a code rate higher than 1;
whether not to use channel encoding on a physical layer;
whether to use channel encoding or joint source-channel encoding on a non-physical layer;
whether to directly use an input bit as an output bit for channel encoding on a physical layer; and
whether channel encoding on a physical layer includes at least two parts, a cyclic redundancy check (Cyclic Redundancy Check, CRC) part and a part directly using an input bit as an output bit.

In this way, after receiving the encoding and decoding indication information, the first communication device can perform encoding or decoding based on the instruction, or send the encoding and decoding indication information to the second communication device to instruct the second communication device to perform encoding or decoding.

The code rate refers to a ratio of the number of input bits to the number of output bits in encoding. In the channel encoding on a physical layer including least the CRC part and the part directly using an input bit as an output bit, the CRC may be parity check bits (parity check bits) of 16 bits or 24 bits configured to determine whether received bits are correct.

Optionally, the encoding and decoding indication information further includes at least one of the following:
the number of input bits and the number of output bits of each level in the multi-level structure;
the total number of input bits of encoding using the multi-level structure;
indication information of a network used by the second communication device;
the total number of input bits of decoding of the second communication device;
the total number of output bits of decoding of the second communication device;
decoding processing information of the multi-level structure; and
the total number of input bits of decoding using the multi-level structure.

The total number of input bits of encoding using the multi-level structure is used as the total number of output bits of decoding of the second communication device; and the decoding processing information of the multi-level structure may be the total number of input bits of decoding. The indication information of the network used by the second communication device can indicate that a suitable network is at least a two-level structure.

Optionally, the encoding and decoding indication information is indicated through a modulation and coding scheme (Modulation and Coding Scheme, MCS) table, where the MCS table is used for indicating at least one of a code rate and a modulation manner.

In this way, the first communication device may determine an encoding or decoding implementation of transmission through an indicated MCS table, and may indicate an MCS table to the second communication device to cause the second communication device to perform corresponding encoding or decoding processing.

In order to know the capability of the second communication device to perform more suitable encoding or decoding, in this embodiment, the method further includes:
obtaining encoding and decoding capability information of the second communication device, where the encoding and decoding capability information includes at least one of the following:
whether to use channel encoding;
whether to use joint source-channel encoding;
whether to use a type of encoding with a code rate higher than 1;
whether not to use channel encoding on a physical layer;
whether to use channel encoding or joint source-channel encoding on a non-physical layer;
whether to directly use an input bit as an output bit directly for channel encoding on a physical layer; and
whether channel encoding on a physical layer includes at least two parts, a CRC part and a part directly using an input bit as an output bit.

Certainly, the first communication device may also inform the second communication device of encoding and decoding capability information of the first communication device.

Optionally, in this embodiment, the method further includes:
obtaining an encoding and decoding parameter, where the encoding and decoding parameter includes at least one of the following:
a physical layer-related parameter;
a computing resource-related parameter;
a service-related parameter;
a network-related parameter; and
parameter indication information.

In this way, the first communication device can perform encoding or decoding based on the encoding or decoding parameter. Certainly, the encoding and decoding parameter is sent and informed by the second communication device or activated in a preconfiguration.

If the preconfiguration includes a parameter set of one or more of the physical layer-related parameter, the computing resource-related parameter, the service-related parameter, and the network-related parameter, and the parameter indication information corresponds to the parameter set, a specific parameter is obtained from the corresponding parameter set through the parameter indication information.

Certainly, the encoding and decoding parameter may also be informed by the first communication device to the second communication device.

Optionally, the physical layer-related parameter includes at least one of the following:
an available physical resource; and
a channel type.

The channel type includes at least one of: a signal-to-noise ratio, a doppler spread (Doppler spread), and a delay spread (Delay spread).

Optionally, the computing resource-related parameter includes at least one of the following:
a network size that can be handled;
a network depth that can be handled; and
a network type that can be handled.

Optionally, the service-related parameter includes at least one of the following:
the number of bits to be transmitted;
a target quality of service; and
a service type.

The target quality of service QOS may include a user experience parameter, such as luminance, quality, or the like which may affect the user experience. The service type at least includes a service feature, such as content in an image, a video, a voice, or text. Historical experience may be generated according to a pre-defined principle. For example, corresponding historical experience is generated according to a preconfigured deep learning neural network. The historical experience may implicitly include evaluation on a signal satisfaction degree of the second communication device.

Optionally, the network-related parameter includes at least one of the following:
a network type;
a network coefficient; and
an activation function type.

The network type, the network coefficient, and the activation function type may be corresponding content of the deep learning neural network used for joint source-channel coding. Certainly, the network-related parameter may also be implemented by identifying indication information of at least one of the network type, the network coefficient, and the activation function type. From the indication information, one or more of a network type, a network coefficient, or an activation function type corresponding to an identifier can be determined.

Optionally, in this embodiment, the encoding and decoding parameter is preconfigured or indicated through at least one of the following target sources:
a physical layer of the user-side device;
a medium access control (Medium Access Control, MAC) layer of the user-side device;
radio resource control (Radio Resource Control, RRC) of the user-side device;
an application layer of the user-side device;
a physical layer of the network-side device;
a MAC layer of the network-side device;
RRC of the network-side device; and
a control node.

An interaction of encoding and decoding parameters between devices may also be an interaction of indication information of the encoding and decoding parameters other than a direct interaction of the encoding and decoding parameters. The indication information of the encoding and decoding parameter may be indicated explicitly or implicitly (for example, included in data). Specifically, the preconfiguration includes a parameter set of one or more of the physical layer-related parameter, the computing resource-related parameter, the service-related parameter, the network-related parameter, an algorithm parameter required by encoding of a transmit end, an overall evaluation parameter, and the parameter indication information. The indication information of the encoding and decoding parameter may correspond to one parameter set thereof.

Certainly, if the indication information of the encoding and decoding parameter does not exist, a preconfiguration parameter may be used.

Optionally, in this embodiment, if encoding of the first communication device for data transmission is decoding facilitating the second communication device, the method further includes:
carrying first information and/or second information through control information, where
the first information is information configured to perform joint decoding; and
the second information is information configured to forward a decoded packet.

Specifically, the first information and/or the second information may be carried through physical layer control information (DCI/UCI) or may be carried through a MAC CE. In addition, the first information and/or the second information may be processed through separate encoding.

In this embodiment, considering that different service types have different data transmission requirements, optionally, the method further includes:
receiving, in a case that the first communication device is a network-side device, one or more service types of to be transmitted data and state information of to be transmitted data corresponding to each service type reported by the user-side device.

Optionally, the method further includes:
reporting, in a case that the first communication device is a user-side device, one or more service types of to be transmitted data and state information of to be transmitted data corresponding to each service type.

In this way, when the one or more service types of to be transmitted data and state information of to be transmitted data corresponding to each service type reported by the user-side device are received, the network-side device can perform reasonable encoding or decoding for the service type and the data state.

In conclusion, according to the method of the embodiments of the present invention, encoding or decoding may be performed by using a multi-level structure, or a second communication device may be instructed to perform encoding or decoding by using a multi-level structure, to effectively reduce time consumption of encoding or decoding processing during transmission.

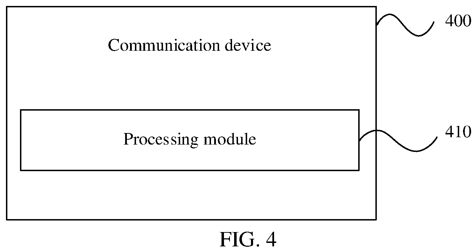

FIG 4 is a block diagram of a communication device according to an embodiment of the present invention. A communication device 400 shown in FIG. 4 is a first communication device including a processing module 410.

The processing module 410 is configured to perform encoding or decoding, or, instruct a second communication device to perform encoding or decoding, where the encoding or decoding uses a multi-level structure.

Optionally, in a case that the first communication device is a network-side device, different parts of the multi-level structure are processed in different network elements or modules of the network-side device.

Optionally, there are interfaces between the different network elements or modules, and encoding information or decoding information required by the different parts of the multi-level structure are exchanged through the interfaces.

Optionally, the multi-level structure includes at least a first part and a second part,
where the number of output bits in encoding of the first part is greater than or equal to the number of input bits in encoding of the first part, and the number of output bits in encoding of the second part is smaller than or equal to the number of input bits in encoding of the second part; and the number of output bits in decoding of the first part is smaller than the number of input bits in decoding of the first part, and the number of output bits in decoding of the second part is greater than the number of input bits in decoding of the second part.

Optionally, the device further includes:
a receiving and sending module, configured to send or receive encoding and decoding indication information of encoding and decoding, where the encoding and decoding indication information includes at least one of the following:
whether to use channel encoding;
whether to use joint source-channel encoding;
whether to use a type of encoding with a code rate higher than 1;
whether not to use channel encoding on a physical layer;
whether to use channel encoding or joint source-channel encoding on a non-physical layer;
whether to directly use an input bit as an output bit for channel encoding on a physical layer; and
whether channel encoding on a physical layer includes at least two parts, a CRC part and a part directly using an input bit as an output bit.

Optionally, the device further includes:
a first obtaining module, configured to obtain encoding and decoding capability information of the second communication device, where the encoding and decoding capability information includes at least one of the following:
whether to use channel encoding;
whether to use joint source-channel encoding;
whether to use a type of encoding with a code rate higher than 1;
whether not to use channel encoding on a physical layer;
whether to use channel encoding or joint source-channel encoding on a non-physical layer;
whether to directly use an input bit as an output bit for channel encoding on a physical layer; and
whether channel encoding on a physical layer includes at least two parts, a CRC part and a part directly using an input bit as an output bit.

Optionally, the encoding and decoding indication information further includes at least one of the following:
the number of input bits and the number of output bits of each level in the multi-level structure;
the total number of input bits of encoding using the multi-level structure;
indication information of a network used by the second communication device;
the total number of input bits of decoding of the second communication device;
the total number of output bits of decoding of the second communication device; decoding processing information of the multi-level structure; and
the total number of input bits of decoding using the multi-level structure.

Optionally, the encoding and decoding indication information is indicated through a modulation and coding scheme MCS table, where the MCS table is used for indicating at least one of a code rate and a modulation manner.

Optionally, the device further includes:
a second obtaining module, configured to obtain an encoding and decoding parameter, where the encoding and decoding parameter includes at least one of the following:
a physical layer-related parameter;
a computing resource-related parameter;
a service-related parameter;
a network-related parameter; and
parameter indication information.

Optionally, the physical layer-related parameter includes at least one of the following:
an available physical resource; and
a channel type.

Optionally, the computing resource-related parameter includes at least one of the following:
a network size that can be handled;
a network depth that can be handled; and
a network type that can be handled.

Optionally, the service-related parameter includes at least one of the following:
the number of bits to be transmitted;
a target quality of service; and
a service type.

Optionally, the network-related parameter includes at least one of the following:
a network type;
a network coefficient; and
an activation function type.

Optionally, the encoding and decoding parameter is preconfigured or indicated through at least one of the following target sources:
a physical layer of a user-side device;
a medium access control MAC layer of a user-side device;
radio resource control RRC of a user-side device;
an application layer of a user-side device;
a physical layer of a network-side device;
a MAC layer of a network-side device;
RRC of a network-side device; and
a control node.

Optionally, the device further includes:
a receiving module, configured to receive, in a case that the first communication device is a network-side device, one or more service types of to be transmitted data and state information of to be transmitted data corresponding to each service type reported by a user-side device.

Optionally, the device further includes:
a sending module, configured to report, in a case that the first communication device is a user-side device, one or more service types of to be transmitted data and state information of to be transmitted data corresponding to each service type in a case that.

The communication device 400 can implement each process implemented by the first communication device in the method embodiments in FIG. 1 to FIG. 3, and details are not described herein again to avoid repetition. The communication device in the embodiments of the present invention may perform encoding or decoding by using the multi-level structure, or instruct the second communication device to perform encoding or decoding by using the multi-level structure, to effectively reduce time consumption of encoding and decoding processing during transmission.

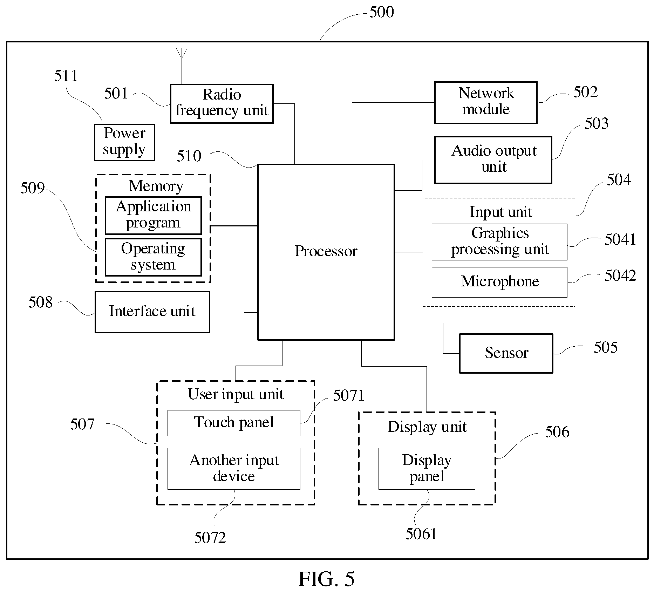

FIG. 5 is a schematic diagram of a hardware structure of a communication device which implements the embodiments of the present invention. The communication device 500 is a first communication device, and includes, but not limited to: components such as a radio frequency unit 501, a network module 502, an audio output unit 503, an output unit 504, a sensor 505, a display unit 506, a user input unit 507, an interface unit 508, a memory 509, a processor 510, and a power supply 511. A person skilled in the art can understand that the structure of the communication device shown in FIG. 5 does not constitute a limitation to the communication device, and the communication device may include more or fewer components than those shown in the figure, or combine some components, or have a different component deployment. In the embodiments of the present invention, the communication device includes, but not limited to, a mobile phone, a tablet computer, a notebook computer, a palmtop computer, an in-vehicle terminal, a wearable device, a pedometer, or the like.

The processor 510 is configured to perform encoding or decoding, or instruct a second communication device to perform encoding or decoding, where the encoding or decoding uses a multi-level structure.

Therefore, the communication device may perform encoding or decoding by using the multi-level structure, or instruct the second communication device to perform encoding or decoding by using the multi-level structure, to effectively reduce time consumption of encoding and decoding processing during transmission.

It should be understood that, in the embodiments of the present invention, the radio frequency unit 501 may be configured to receive and send information or receive and send a signal during a call. Specifically, after downlink data from a base station is received, the downlink data is sent to the processor 510 for processing. In addition, the radio frequency unit sends uplink data to the base station. Generally, the radio frequency unit 501 includes, but not limited to, an antenna, at least one amplifier, a transceiver, a coupler, a low noise amplifier, a duplexer, or the like. In addition, the radio frequency unit 501 may further communicate with a network or another device through a wireless communication system.

The communication device provides, through the network module 502, wireless broadband Internet access for a user, such as helping the user receive or send an email, browse a web page, and access stream media.

The audio output unit 503 may convert audio data received by the radio frequency unit 501 or the network module 502 or stored in the memory 509 into an audio signal and output the audio signal as a sound. In addition, the audio output unit 503 may further provide audio output (e.g. a call signal reception sound and a message reception sound) related to specific functions implemented by the communication device 500. The audio output unit 503 includes a speaker, a buzzer, a telephone receiver, or the like.

The input unit 504 is configured to receive audio or video signals. The input unit 504 may include a graphics processing unit (Graphics Processing Unit, GPU) 5041 and a microphone 5042, where the graphics processing unit 5041 processes image data of a static picture or a video that is obtained by an image capturing device (for example a camera) in a video capturing mode or an image capturing mode. Processed image frames may be displayed on the display unit 506. The image frames processed by the graphics processing unit 5041 may be stored in the memory 509 (or another storage medium) or sent through the radio frequency unit 501 or the network module 502. The microphone 5042 may receive sounds and process the sounds into audio data. The processed audio data may be converted, in a phone call mode, into an output in a form that can be sent by the radio frequency unit 501 to a mobile communication base station.

The communication device 500 further includes at least one sensor 505, such as an optical sensor, a motion sensor, or another sensor. Specifically, the optical sensor includes an ambient light sensor and a proximity sensor, where the ambient light sensor can adjust luminance of a display panel 5061 according to brightness of the ambient light, and the proximity sensor can switch off the display panel 5061 and/or backlight when the communication device 500 is moved to the ear. As one type of motion sensor, an accelerometer sensor can detect magnitudes of accelerations in various directions (generally, on three axes), can detect a magnitude and a direction of the gravity when static, and can be configured to recognize the attitude of the communication device (for example, switching between landscape orientation and portrait orientation, a related game, and magnetometer attitude calibration), and a function related to vibration recognition (such as a pedometer and a knock). The sensor 505 may further include a fingerprint sensor, a pressure sensor, an iris sensor, a molecular sensor, a gyroscope, a barometer, a hygrometer, a thermometer, an infrared sensor, and the like, and details are not described herein again.

The display unit 506 is configured to display information input by the user or information provided for the user. The display unit 506 may include a display panel 5061, and the display panel 5061 may be configured by using a liquid crystal display (Liquid Crystal Display, LCD) or an organic light-emitting diode (Organic Light-Emitting Diode, OLED).

The user input unit 507 may be configured to receive input digit or character information, and generate a key signal input related to the user setting and function control of the communication device. Specifically, the user input unit 507 includes a touch panel 5071 and another input device 5072. The touch panel 5071, also called as a touch screen, may collect a touch operation of the user on or near the touch panel (for example, an operation of the user on or near the touch panel 5071 by using any suitable object or attachment, such as a finger or a stylus). The touch panel 5071 may include two parts: a touch detection apparatus and a touch controller. The touch detection apparatus detects a touch orientation of the user, detects a signal brought by the touch operation, and transmits the signal to the touch controller. The touch controller receives touch information from the touch detection apparatus, converts the touch information into contact coordinates, sends the contact coordinates to the processor 510, and receives and executes a command sent by the processor 510. In addition, the touch panel 5071 may be implemented by using various types, such as a resistive type, a capacitive type, an infrared type, and a surface acoustic wave type. In addition to the touch panel 5071, the user input unit 507 may further include the another input device 5072. Specifically, the another input device 5072 may include, but not limited to, a physical keyboard, a functional key (such as a volume control key or a switch key), a track ball, a mouse, and a joystick, which is not described herein again.

Furthermore, the touch panel 5071 may cover the display panel 5061. After detecting a touch operation on or near the touch panel, the touch panel 5061 transmits the touch operation to the processor 510, to determine a type of a touch event. The processor 510 then provides a corresponding visual output on the display panel 5061 according to the type of the touch event. Although in FIG. 5, the touch panel 5071 and the display panel 5061 implement, as two independent parts, input and output functions of the communication device, in some embodiments, the touch panel 5071 and the display panel 5061 may be integrated to implement the input and output functions of the communication device, and details are not limited herein.

The interface unit 508 is an interface for connecting an external apparatus and the communication device 500. For example, the external apparatus may include a wired or wireless headset port, an external power supply (or battery charger) port, a wired or wireless data port, a memory card port, a port for connecting apparatus with a recognition module, an audio input/output (I /O) port, a video I/O port, a headphone port, and the like. The interface unit 508 may be configured to receive input (for example, data information or power) from the external apparatus and transmit the received input to one or more elements in the communication device 500 or may be configured to transmit data between the communication device 500 and the external apparatus.

The memory 509 may be configured to store a software program and various data. The memory 509 may mainly include a program storage area and a data storage area. The program storage area may store an operating system, an application program required by at least one function (such as a sound playback function and an image display function), and the like. The data storage area may store data (such as audio data and a phone book) created according to use of a mobile phone. In addition, the memory 509 may include a high-speed random access memory, and may further include a non-volatile memory, such as at least one magnetic disk storage device, a flash memory device, or other volatile solid state storage devices.

The processor 510 is a control center of the communication device, and connects to various parts of the communication device by using various interfaces and lines. By running or executing the software program and/or module stored in the memory 509, and invoking data stored in the memory 509, the processor performs various functions and data processing of the communication device, so as to perform overall monitoring on the communication device. The processor 510 may include one or more processing units. Preferably, the processor 510 may integrate an application processor and a modem processor, where the application processor mainly processes an operating system, a user interface, an application program, and the like, and the modem processor mainly processes wireless communication. It may be understood that the modem processor may not be integrated into the processor 510.

The communication device 500 may further include the power supply 511 (such as a battery) for supplying power to the components. Preferably, the power supply 511 may be logically connected to the processor 510 through a power management system, so as to implement functions such as charging, discharging, and power consumption management through the power management system.

In addition, the communication device 500 includes some functional modules that are not shown, which are not described in detail herein.

Preferably, the embodiments of the present invention further provide a mobile terminal, including a processor, a memory, and a computer program stored in the memory and executable on the processor. When the computer program is executed by the processor, processes of the embodiments of the transmission processing methods are implemented and same technical effects can be achieved. Details are not described herein again to avoid repetition.

The embodiments of the present invention further provide a computer-readable storage medium, storing a computer program. When the computer program is executed by a processor, processes of the embodiments of the transmission processing methods are implemented and same technical effects can be achieved. Details are not described herein again to avoid repetition. The computer-readable storage medium is, for example, a read-only memory (Read-Only Memory, ROM), a random access memory (Random Access Memory, RAM), a magnetic disk, or an optical disk.

It may be understood that these disclosed embodiments may be implemented by using hardware, software, firmware, middleware, microcode, or a combination thereof. For hardware implementation, modules, units, sub-modules, and sub-units may be implemented in one or more application specific integrated circuits (Application Specific Integrated Circuit, ASIC), a digital signal processor (Digital Signal Processing, DSP), a DSP device (DSP Device, DSPD), a programmable logic device (Programmable Logic Device, PLD), a field-programmable gate array (Field-Programmable Gate Array, FPGA), a general-purpose processor, a controller, a microcontroller, a microprocessor, another electronic unit configured to implement the functions of this application, or a combination thereof.

It should be noted that, in this specification, the terms "include", "comprise", or any other variants are intended to cover a non-exclusive inclusion, so that a process, method, object, or device including a series of elements not only includes those elements, but also includes other elements not clearly listed or includes intrinsic elements for the process, method, object, or device. Without more limitations, an element limited by a sentence "including one ..." does not exclude that there are still other same elements in the process, method, object, or device including the element.

Through the descriptions of the foregoing embodiments, a person skilled in the art may clearly understand that the methods according to the foregoing embodiments may be implemented by means of software and a necessary general hardware platform, and certainly, may also be implemented by means of hardware, but in many cases, the former is a better implementation. Based on such understanding, the technical solutions of the present invention essentially, or the part contributing to the related art, may be presented in the form of a software product. The computer software product is stored in a storage medium (such as a ROM/RAM, a magnetic disk, or an optical disk) including several instructions to enable a terminal (which may be a mobile phone, a computer, a server, an air conditioner, or a network device) to perform the methods described in the embodiments of the present invention.

## Claims

1. A transmission processing method, performed by a first communication device and comprising:
performing (101) encoding or decoding, or instructing a second communication device to perform encoding or decoding, wherein the encoding or decoding uses a multi-level structure and wherein the encoding or decoding is based on a deep learning neural network; wherein
the first communication device and second communication device is either a user-side device or a network-side device, respectively, and the multi-level structure comprises at least a first part and a second part; wherein
the first part is configured to perform either channel encoding or channel decoding, the second part is configured to perform either source encoding or source decoding, and the deep learning neural network is configured to perform either joint source-channel encoding or joint source-channel decoding;
wherein the method further comprises:
sending or receiving encoding and decoding indication information, wherein the encoding and decoding indication information comprises at least one of the following:
whether to use channel encoding;
whether to use joint source-channel encoding;
whether to use a type of encoding with a code rate higher than 1;
whether not to use channel encoding on a physical layer;
whether to use channel encoding or joint source-channel encoding on a non-physical layer;
whether to directly use an input bit as an output bit for channel encoding on a physical layer; and
whether channel encoding on a physical layer comprises at least two parts as follows: a cyclic redundancy check, CRC, part, and a part directly using an input bit as an output bit;
or
the method further comprises:
obtaining encoding and decoding capability information of the second communication device, wherein the encoding and decoding capability information comprises at least one of the following:
whether the second communication device can use channel encoding;
whether the second communication device can use joint source-channel encoding;
whether the second communication device can use a type of encoding with a code rate higher than 1;
whether the second communication device can use channel encoding on a physical layer;
whether the second communication device can use channel encoding or joint source-channel encoding on a non-physical layer;
whether the second communication device can directly use an input bit as an output bit for channel encoding on a physical layer; and
whether channel encoding on a physical layer that can be used by the second communication device comprises at least two parts as follows: a CRC part, and a part directly using an input bit as an output bit.

2. The method according to claim 1, wherein in a case that the first communication device is the network-side device, different parts of the multi-level structure are processed in different network elements or modules of the network-side device.

3. The method according to claim 2, wherein there are interfaces between the different network elements or modules, and encoding information or decoding information required by the different parts of the multi-level structure are exchanged through the interfaces.

4. The method according to claim 1, wherein the encoding and decoding indication information further comprises at least one of following:
the number of input bits and the number of output bits of each level in the multi-level structure;
the total number of input bits of encoding using the multi-level structure;
indication information of a network used by the second communication device;
the total number of input bits of decoding of the second communication device;
the total number of output bits of decoding of the second communication device;
decoding processing information of the multi-level structure; and
the total number of input bits of decoding using the multi-level structure; wherein
the network is the multi-level structure.

5. The method according to claim 1, further comprising:
obtaining an encoding and decoding parameter, wherein the encoding and decoding parameter comprises at least one of following:
a physical layer-related parameter;
a computing resource-related parameter;
a service-related parameter;
a network-related parameter; and
parameter indication information; wherein
the computing resource-related parameter comprises at least one of following: a deep learning neural network size that can be handled, a deep learning neural network depth that can be handled, and a deep learning neural network type that can be handled;
the network-related parameter includes at least one of following: a network type, a network coefficient, and an activation function type; and
from the parameter indication information, one or more of a network type, a network coefficient, or an activation function type corresponding to an identifier can be determined .

6. The method according to claim 1, further comprising:
receiving, in a case that the first communication device is the network-side device, one or more service types of to be transmitted data and state information of to be transmitted data corresponding to each service type reported by a user-side device.

7. The method according to claim 1, further comprising:
reporting, in a case that the first communication device is the user-side device, one or more service types of to-be-transmitted data and state information of to-be-transmitted data corresponding to each service type.

8. A first communication device (400), comprising:
a processing module (410), configured to perform encoding or decoding, or instruct a second communication device to perform encoding or decoding, wherein the encoding or decoding uses a multi-level structure and wherein the encoding or decoding is based on a deep learning neural network; wherein
the first communication device and the second communication device is either a user-side device or a network-side device, respectively, and the multi-level structure comprises at least a first part and a second part; wherein
the first part is configured to perform either channel coding or channel decoding the second part is configured to perform either source coding or source decoding, and the deep learning neural network is configured to perform either joint source-channel coding or joint source-channel decoding;
wherein the first communication device (400) further includes:
a receiving and sending module, configured to send or receive encoding and decoding indication information of encoding and decoding, where the encoding and decoding indication information includes at least one of the following:
whether to use channel encoding;
whether to use joint source-channel encoding;
whether to use a type of encoding with a code rate higher than 1;
whether not to use channel encoding on a physical layer;
whether to use channel encoding or joint source-channel encoding on a non-physical layer;
whether to directly use an input bit as an output bit for channel encoding on a physical layer; and
whether channel encoding on a physical layer includes at least two parts as follows: a cyclic redundancy check, CRC, part, and a part directly using an input bit as an output bit;
or
the communication device(400) further includes:
a first obtaining module, configured to obtain encoding and decoding capability information of the second communication device, where the encoding and decoding capability information includes at least one of the following:
whether the second communication device can use channel encoding;
whether the second communication device can use joint source-channel encoding;
whether the second communication device can use a type of encoding with a code rate higher than 1;
whether the second communication device can use channel encoding on a physical layer;
whether the second communication device can use channel encoding or joint source-channel encoding on a non-physical layer;
whether the second communication device can directly use an input bit as an output bit for channel encoding on a physical layer; and
whether channel encoding on a physical layer that can be used by the second communication device comprises at least two parts as follows; a CRC part, and a part directly using an input bit as an output bit.

9. The device (400) according to claim 8, wherein in a case that the first communication device (400) is the network-side device, different parts of the multi-level structure are processed in different network elements or modules of the network-side device.

10. The device (400) according to claim 9, wherein there are interfaces between the different network elements or modules, and encoding information or decoding information required by the different parts of the multi-level structure are exchanged through the interfaces.

11. A computer-readable storage medium, storing a computer program, wherein when the computer program is executed by a processor (510), steps of the transmission processing method according to any one of claims 1 to 7 are implemented.

## Patentansprüche

1. Ein Übertragungsverarbeitungsverfahren, das von einer ersten Kommunikationsvorrichtung durchgeführt wird und Folgendes beinhaltet:
Durchführen (101) von Codierung oder Decodierung oder Anweisen einer zweiten Kommunikationsvorrichtung, Codierung oder Decodierung durchzuführen, wobei die Codierung oder Decodierung eine mehrstufige Struktur verwendet und wobei die Codierung oder Decodierung auf einem neuronalen Deep-Learning-Netzwerk basiert;
wobei
die erste Kommunikationsvorrichtung und die zweite Kommunikationsvorrichtung jeweils entweder eine benutzerseitige Vorrichtung oder eine netzwerkseitige Vorrichtung sind und die mehrstufige Struktur mindestens einen ersten Teil und einen zweiten Teil beinhaltet; wobei
der erste Teil konfiguriert ist, um entweder Kanalcodierung oder Kanaldecodierung durchzuführen, der zweite Teil konfiguriert ist, um entweder Quellencodierung oder Quellendecodierung durchzuführen, und das neuronale Deep-Learning-Netzwerk konfiguriert ist, um entweder gemeinsame Quellen-Kanal-Codierung oder gemeinsame Quellen-Kanal-Decodierung durchzuführen,
wobei
das Verfahren ferner Folgendes beinhaltet:
Senden oder Empfangen von Codierungs- und Decodierungsanzeigeinformationen,
wobei die Codierungs- und Decodierungsanzeigeinformationen mindestens eines der Folgenden beinhalten:
ob Kanalcodierung verwendet werden soll;
ob gemeinsame Quellen-Kanal-Codierung verwendet werden soll;
ob ein Codierungstyp mit einer Code-Rate von mehr als 1 verwendet werden soll;
ob Kanalcodierung auf einer physikalischen Schicht nicht verwendet werden soll;
ob Kanalcodierung oder gemeinsame Quellen-Kanal-Codierung auf einer nicht physikalischen Schicht verwendet werden soll;
ob direkt ein Eingangsbit als ein Ausgangsbit für Kanalcodierung auf einer physikalischen Schicht verwendet werden soll; und
ob Kanalcodierung auf einer physikalischen Schicht mindestens zwei Teile wie folgt beinhaltet: einen Teil zur zyklischen Redundanzprüfung, CRC, und einen Teil, der direkt ein Eingangsbit als ein Ausgangsbit verwendet;
oder
das Verfahren ferner Folgendes beinhaltet:
Erhalten von Codierungs- und Decodierungsfähigkeitsinformationen der zweiten Kommunikationsvorrichtung, wobei die Codierungs- und
Decodierungsfähigkeitsinformationen mindestens eines der Folgenden beinhalten:
ob die zweite Kommunikationsvorrichtung Kanalcodierung verwenden kann;
ob die zweite Kommunikationsvorrichtung gemeinsame Quellen-Kanal-Codierung verwenden kann;
ob die zweite Kommunikationsvorrichtung einen Codierungstyp mit einer Code-Rate von mehr als 1 verwenden kann;
ob die zweite Kommunikationsvorrichtung Kanalcodierung auf einer physikalischen Schicht verwenden kann;
ob die zweite Kommunikationsvorrichtung Kanalcodierung oder gemeinsame Quellen-Kanal-Codierung auf einer nicht physikalischen Schicht verwenden kann;
ob die zweite Kommunikationsvorrichtung direkt ein Eingangsbit als ein Ausgangsbit für Kanalcodierung auf einer physikalischen Schicht verwenden kann; und
ob Kanalcodierung auf einer physikalischen Schicht, die von der zweiten Kommunikationsvorrichtung verwendet werden kann, mindestens zwei Teile wie folgt beinhaltet: einen CRC-Teil und einen Teil, der direkt ein Eingangsbit als ein Ausgangsbit verwendet.

2. Verfahren gemäß Anspruch 1, wobei in einem Fall, in dem die erste Kommunikationsvorrichtung die netzwerkseitige Vorrichtung ist, verschiedene Teile der mehrstufigen Struktur in verschiedenen Netzwerkelementen oder -modulen der netzwerkseitigen Vorrichtung verarbeitet werden.

3. Verfahren gemäß Anspruch 2, wobei Schnittstellen zwischen den verschiedenen Netzwerkelementen oder -modulen vorhanden sind und Codierungsinformationen oder Decodierungsinformationen, die von den verschiedenen Teilen der mehrstufigen Struktur benötigt werden, über die Schnittstellen ausgetauscht werden.

4. Verfahren gemäß Anspruch 1, wobei die Codierungs- und Decodierungsanzeigeinformationen ferner mindestens eines der Folgenden beinhalten:
die Anzahl von Eingangsbits und die Anzahl von Ausgangsbits jeder Stufe in der mehrstufigen Struktur;
die Gesamtanzahl von Eingangsbits der Codierung unter Verwendung der mehrstufigen Struktur;
Anzeigeinformationen eines Netzwerks, das von der zweiten Kommunikationsvorrichtung verwendet wird;
die Gesamtanzahl von Eingangsbits der Decodierung der zweiten Kommunikationsvorrichtung;
die Gesamtanzahl von Ausgangsbits der Decodierung der zweiten Kommunikationsvorrichtung;
Decodierungsverarbeitungsinformationen der mehrstufigen Struktur; und
die Gesamtanzahl von Eingangsbits der Decodierung unter Verwendung der mehrstufigen Struktur; wobei
das Netzwerk die mehrstufige Struktur ist.

5. Verfahren gemäß Anspruch 1, das ferner Folgendes beinhaltet:
Erhalten eines Codierungs- und Decodierungsparameters, wobei der Codierungs- und Decodierungsparameter mindestens eines der Folgenden beinhaltet:
einen auf die physikalische Schicht bezogenen Parameter;
einen rechenressourcenbezogenen Parameter;
einen dienstbezogenen Parameter;
einen netzwerkbezogenen Parameter; und
Parameteranzeigeinformationen; wobei
der rechenressourcenbezogene Parameter mindestens eines der Folgenden beinhaltet:
eine Größe des neuronalen Deep-Learning-Netzwerks, die gehandhabt werden kann,
eine Tiefe des neuronalen Deep-Learning-Netzwerks, die gehandhabt werden kann,
und einen Typ des neuronalen Deep-Learning-Netzwerks, der gehandhabt werden kann;
der netzwerkbezogene Parameter mindestens eines der Folgenden umfasst: einen Netzwerktyp, einen Netzwerkkoeffizienten und einen Aktivierungsfunktionstyp; und
aus den Parameteranzeigeinformationen eines oder mehrere von einem Netzwerktyp, einem Netzwerkkoeffizienten oder einem Aktivierungsfunktionstyp entsprechend einer Kennung bestimmt werden können.

6. Verfahren gemäß Anspruch 1, das ferner Folgendes beinhaltet:
Empfangen, in einem Fall, in dem die erste Kommunikationsvorrichtung die netzwerkseitige Vorrichtung ist, eines oder mehrerer Diensttypen von zu übertragenden Daten und Zustandsinformationen von zu übertragenden Daten entsprechend jedem Diensttyp, die von einer benutzerseitigen Vorrichtung gemeldet werden.

7. Verfahren gemäß Anspruch 1, das ferner Folgendes beinhaltet:
Melden, in einem Fall, in dem die erste Kommunikationsvorrichtung die benutzerseitige Vorrichtung ist, eines oder mehrerer Diensttypen von zu übertragenden Daten und Zustandsinformationen von zu übertragenden Daten entsprechend jedem Diensttyp.

8. Eine erste Kommunikationsvorrichtung (400), die Folgendes beinhaltet:
ein Verarbeitungsmodul (410), das konfiguriert ist, um Codierung oder Decodierung durchzuführen oder eine zweite Kommunikationsvorrichtung anzuweisen, Codierung oder Decodierung durchzuführen, wobei die Codierung oder Decodierung eine mehrstufige Struktur verwendet und wobei die Codierung oder Decodierung auf einem neuronalen Deep-Learning-Netzwerk basiert; wobei
die erste Kommunikationsvorrichtung und die zweite Kommunikationsvorrichtung jeweils entweder eine benutzerseitige Vorrichtung oder eine netzwerkseitige Vorrichtung sind und die mehrstufige Struktur mindestens einen ersten Teil und einen zweiten Teil beinhaltet; wobei
der erste Teil konfiguriert ist, um entweder Kanalcodierung oder Kanaldecodierung durchzuführen, der zweite Teil konfiguriert ist, um entweder Quellencodierung oder
Quellendecodierung durchzuführen, und das neuronale Deep-Learning-Netzwerk konfiguriert ist, um entweder gemeinsame Quellen-Kanal-Codierung oder gemeinsame Quellen-Kanal-Decodierung durchzuführen; wobei
die erste Kommunikationsvorrichtung (400) ferner Folgendes umfasst:
ein Empfangs- und Sendemodul, das konfiguriert ist, um Codierungs- und Decodierungsanzeigeinformationen von Codierung und Decodierung zu senden oder zu empfangen, wobei die Codierungs- und Decodierungsanzeigeinformationen mindestens eines der Folgenden umfassen:
ob Kanalcodierung verwendet werden soll;
ob gemeinsame Quellen-Kanal-Codierung verwendet werden soll;
ob ein Codierungstyp mit einer Code-Rate von mehr als 1 verwendet werden soll;
ob Kanalcodierung auf einer physikalischen Schicht nicht verwendet werden soll;
ob Kanalcodierung oder gemeinsame Quellen-Kanal-Codierung auf einer nicht physikalischen Schicht verwendet werden soll;
ob direkt ein Eingangsbit als ein Ausgangsbit für Kanalcodierung auf einer physikalischen Schicht verwendet werden soll; und
ob Kanalcodierung auf einer physikalischen Schicht mindestens zwei Teile wie folgt umfasst: einen Teil zur zyklischen Redundanzprüfung, CRC, und einen Teil, der direkt ein Eingangsbit als ein Ausgangsbit verwendet;
oder
die Kommunikationsvorrichtung (400) ferner Folgendes umfasst:
ein erstes Erhaltemodul, das konfiguriert ist, um Codierungs- und
Decodierungsfähigkeitsinformationen der zweiten Kommunikationsvorrichtung zu erhalten, wobei die Codierungs- und Decodierungsfähigkeitsinformationen mindestens eines der Folgenden umfassen:
ob die zweite Kommunikationsvorrichtung Kanalcodierung verwenden kann;
ob die zweite Kommunikationsvorrichtung gemeinsame Quellen-Kanal-Codierung verwenden kann;
ob die zweite Kommunikationsvorrichtung einen Codierungstyp mit einer Code-Rate von mehr als 1 verwenden kann;
ob die zweite Kommunikationsvorrichtung Kanalcodierung auf einer physikalischen Schicht verwenden kann;
ob die zweite Kommunikationsvorrichtung Kanalcodierung oder gemeinsame Quellen-Kanal-Codierung auf einer nicht physikalischen Schicht verwenden kann;
ob die zweite Kommunikationsvorrichtung direkt ein Eingangsbit als ein Ausgangsbit für Kanalcodierung auf einer physikalischen Schicht verwenden kann; und
ob Kanalcodierung auf einer physikalischen Schicht, die von der zweiten Kommunikationsvorrichtung verwendet werden kann, mindestens zwei Teile wie folgt beinhaltet: einen CRC-Teil und einen Teil, der direkt ein Eingangsbit als ein Ausgangsbit verwendet.

9. Vorrichtung (400) gemäß Anspruch 8, wobei in einem Fall, in dem die erste Kommunikationsvorrichtung (400) die netzwerkseitige Vorrichtung ist, verschiedene Teile der mehrstufigen Struktur in verschiedenen Netzwerkelementen oder -modulen der netzwerkseitigen Vorrichtung verarbeitet werden.

10. Vorrichtung (400) gemäß Anspruch 9, wobei Schnittstellen zwischen den verschiedenen Netzwerkelementen oder -modulen vorhanden sind und Codierungsinformationen oder Decodierungsinformationen, die von den verschiedenen Teilen der mehrstufigen Struktur benötigt werden, über die Schnittstellen ausgetauscht werden.

11. Ein rechnerlesbares Speichermedium, das ein Rechnerprogramm speichert, wobei, wenn das Rechnerprogramm von einem Prozessor (510) ausgeführt wird, Schritte des Übertragungsverarbeitungsverfahrens gemäß einem der Ansprüche 1 bis 7 implementiert werden.

## Revendications

1. Un procédé de traitement de transmission, réalisé par un premier dispositif de communication et comprenant :
le fait de réaliser (101) un codage ou décodage, ou de donner l'instruction à un deuxième dispositif de communication de réaliser un codage ou décodage, dans lequel le codage ou décodage utilise une structure à niveaux multiples et dans lequel le codage ou décodage est basé sur un réseau neuronal d'apprentissage profond ; dans lequel
le premier dispositif de communication et le deuxième dispositif de communication sont soit un dispositif côté utilisateur, soit un dispositif côté réseau, respectivement, et la structure à niveaux multiples comprend au moins une première partie et une deuxième partie ; dans lequel
la première partie est configurée pour réaliser soit un codage de canal, soit un décodage de canal, la deuxième partie est configurée pour réaliser soit un codage de source, soit un décodage de source, et le réseau neuronal d'apprentissage profond est configuré pour réaliser soit un codage conjoint de source-canal, soit un décodage conjoint de source-canal ;
le procédé comprenant en outre :
le fait d'envoyer ou de recevoir des informations d'indication de codage et de décodage, les informations d'indication de codage et de décodage comprenant au moins l'un des éléments suivants :
s'il faut utiliser un codage de canal ;
s'il faut utiliser un codage conjoint de source-canal ;
s'il faut utiliser un type de codage avec un débit de code supérieur à 1 ;
s'il ne faut pas utiliser un codage de canal sur une couche physique ;
s'il faut utiliser un codage de canal ou un codage conjoint de source-canal sur une couche non physique ;
s'il faut utiliser directement un bit d'entrée en tant que bit de sortie pour un codage de canal sur une couche physique ; et
si un codage de canal sur une couche physique comprend au moins deux parties comme suit : une partie de contrôle de redondance cyclique, CRC, et une partie utilisant directement un bit d'entrée en tant que bit de sortie ;
ou
le procédé comprenant en outre :
le fait d'obtenir des informations de capacité de codage et de décodage du deuxième dispositif de communication, les informations de capacité de codage et de décodage comprenant au moins l'un des éléments suivants :
si le deuxième dispositif de communication peut utiliser un codage de canal ;
si le deuxième dispositif de communication peut utiliser un codage conjoint de source-canal ;
si le deuxième dispositif de communication peut utiliser un type de codage avec un débit de code supérieur à 1 ;
si le deuxième dispositif de communication peut utiliser un codage de canal sur une couche physique ;
si le deuxième dispositif de communication peut utiliser un codage de canal ou un codage conjoint de source-canal sur une couche non physique ;
si le deuxième dispositif de communication peut utiliser directement un bit d'entrée en tant que bit de sortie pour un codage de canal sur une couche physique ; et
si un codage de canal sur une couche physique qui peut être utilisé par le deuxième dispositif de communication comprend au moins deux parties comme suit : une partie CRC, et une partie utilisant directement un bit d'entrée en tant que bit de sortie.

2. Le procédé selon la revendication 1, dans lequel, dans un cas où le premier dispositif de communication est le dispositif côté réseau, des parties différentes de la structure à niveaux multiples sont traitées dans des éléments ou modules de réseau différents du dispositif côté réseau.

3. Le procédé selon la revendication 2, dans lequel il y a des interfaces entre les différents éléments ou modules de réseau, et des informations de codage ou des informations de décodage requises par les différentes parties de la structure à niveaux multiples sont échangées par le biais des interfaces.

4. Le procédé selon la revendication 1, dans lequel les informations d'indication de codage et de décodage comprennent en outre au moins l'un des éléments suivants :
le nombre de bits d'entrée et le nombre de bits de sortie de chaque niveau dans la structure à niveaux multiples ;
le nombre total de bits d'entrée de codage utilisant la structure à niveaux multiples ;
des informations d'indication d'un réseau utilisées par le deuxième dispositif de communication ;
le nombre total de bits d'entrée de décodage du deuxième dispositif de communication ;
le nombre total de bits de sortie de décodage du deuxième dispositif de communication ;
des informations de traitement de décodage de la structure à niveaux multiples ; et
le nombre total de bits d'entrée de décodage utilisant la structure à niveaux multiples ;
dans lequel
le réseau est la structure à niveaux multiples.

5. Le procédé selon la revendication 1, comprenant en outre :
le fait d'obtenir un paramètre de codage et de décodage, dans lequel le paramètre de codage et de décodage comprend au moins l'un des éléments suivants :
un paramètre lié à une couche physique ;
un paramètre lié à une ressource informatique ;
un paramètre lié à un service ;
un paramètre lié à un réseau ; et
des informations d'indication de paramètre ; dans lequel
le paramètre lié à une ressource informatique comprend au moins l'un des éléments suivants : une taille de réseau neuronal d'apprentissage profond qui peut être gérée, une profondeur de réseau neuronal d'apprentissage profond qui peut être gérée, et un type de réseau neuronal d'apprentissage profond qui peut être géré ;
le paramètre lié à un réseau inclut au moins l'un des éléments suivants : un type de réseau, un coefficient de réseau, et un type de fonction d'activation ; et
à partir des informations d'indication de paramètre, un ou plusieurs éléments parmi un type de réseau, un coefficient de réseau, ou un type de fonction d'activation correspondant à un identifiant peuvent être déterminés.

6. Le procédé selon la revendication 1, comprenant en outre :
le fait de recevoir, dans un cas où le premier dispositif de communication est le dispositif côté réseau, un ou plusieurs types de service de données à transmettre et d'informations d'état de données à transmettre correspondant à chaque type de service signalé par un dispositif côté utilisateur.

7. Le procédé selon la revendication 1, comprenant en outre :
le fait de signaler, dans un cas où le premier dispositif de communication est le dispositif côté utilisateur, un ou plusieurs types de service de données à transmettre et d'informations d'état de données à transmettre correspondant à chaque type de service.

8. Un premier dispositif de communication (400), comprenant :
un module de traitement (410), configuré pour réaliser un codage ou décodage, ou donner l'instruction à un deuxième dispositif de communication de réaliser un codage ou décodage, dans lequel le codage ou décodage utilise une structure à niveaux multiples et dans lequel le codage ou décodage est basé sur un réseau neuronal d'apprentissage profond ; dans lequel
le premier dispositif de communication et le deuxième dispositif de communication sont soit un dispositif côté utilisateur, soit un dispositif côté réseau, respectivement, et la structure à niveaux multiples comprend au moins une première partie et une deuxième partie ; dans lequel
la première partie est configurée pour réaliser soit un codage de canal, soit un décodage de canal, la deuxième partie est configurée pour réaliser soit un codage de source, soit un décodage de source, et le réseau neuronal d'apprentissage profond est configuré pour réaliser soit un codage conjoint de source-canal, soit un décodage conjoint de source-canal ;
le premier dispositif de communication (400) incluant en outre :
un module de réception et d'envoi, configuré pour envoyer ou recevoir des informations de codage et de décodage d'indication de codage et de décodage, où les informations d'indication de codage et de décodage incluent au moins l'un des éléments suivants :
s'il faut utiliser un codage de canal ;
s'il faut utiliser un codage conjoint de source-canal ;
s'il faut utiliser un type de codage avec un débit de code supérieur à 1 ;
s'il ne faut pas utiliser un codage de canal sur une couche physique ;
s'il faut utiliser un codage de canal ou un codage conjoint de source-canal sur une couche non physique ;
s'il faut utiliser directement un bit d'entrée en tant que bit de sortie pour un codage de canal sur une couche physique ; et
si un codage de canal sur une couche physique inclut au moins deux parties comme suit : une partie de contrôle de redondance cyclique, CRC, et une partie utilisant directement un bit d'entrée en tant que bit de sortie ;
ou
le dispositif de communication (400) incluant en outre :
un premier module d'obtention, configuré pour obtenir des informations de capacité de codage et de décodage du deuxième dispositif de communication, où les informations de capacité de codage et de décodage incluent au moins l'un des éléments suivants :
si le deuxième dispositif de communication peut utiliser un codage de canal ;
si le deuxième dispositif de communication peut utiliser un codage conjoint de source-canal ;
si le deuxième dispositif de communication peut utiliser un type de codage avec un débit de code supérieur à 1 ;
si le deuxième dispositif de communication peut utiliser un codage de canal sur une couche physique ;
si le deuxième dispositif de communication peut utiliser un codage de canal ou un codage conjoint de source-canal sur une couche non physique ;
si le deuxième dispositif de communication peut utiliser directement un bit d'entrée en tant que bit de sortie pour un codage de canal sur une couche physique ; et
si un codage de canal sur une couche physique qui peut être utilisé par le deuxième dispositif de communication comprend au moins deux parties comme suit : une partie CRC, et une partie utilisant directement un bit d'entrée en tant que bit de sortie.

9. Le dispositif (400) selon la revendication 8, dans lequel, dans un cas où le premier dispositif de communication (400) est le dispositif côté réseau, des parties différentes de la structure à niveaux multiples sont traitées dans des éléments ou modules de réseau différents du dispositif côté réseau.

10. Le dispositif (400) selon la revendication 9, dans lequel il y a des interfaces entre les différents éléments ou modules de réseau, et des informations de codage ou des informations de décodage requises par les différentes parties de la structure à niveaux multiples sont échangées par le biais des interfaces.

11. Un support de stockage lisible par ordinateur, stockant un programme d'ordinateur, dans lequel lorsque le programme d'ordinateur est exécuté par un processeur (510), des étapes du procédé de traitement de transmission selon l'une quelconque des revendications 1 à 7 sont mises en œuvre.
